# DEMANDE DE BREVET EUROPEEN

(11) **EP 3 660 563 A1**
(43) Date de publication de la demande: **03.06.2020**
(21) Numéro de dépôt: 19209599.0
(22) Date de dépôt: 15.11.2019
(51) Int. Cl.: G02B 6/42, H04B 10/80

(54) **TEST DE CIRCUIT PHOTONIQUE INTÉGRÉ**

(30) Priorité: 30.11.2018 FR 1872180
(71) Demandeur: Commissariat à l'Energie Atomique et aux Energies Alternatives, 75015 Paris (FR)
(72) Inventeur: BERNABE, Stéphane, 38054 GRENOBLE CEDEX 9 (FR); GROSSE, Philippe, 38054 GRENOBLE CEDEX 9 (FR)
(74) Mandataire: Cabinet Beaumont

(57) **Abrégé**

La présente description concerne un dispositif de test (2) d'un circuit photonique (1), comprenant une puce photonique de test (20) comportant, du côté d'une première face (201) de la puce : des micro-piliers (202) chacun destiné à être mis en contact avec un plot de connexion électrique (12) correspondant du circuit photonique ; et des premiers ports optiques d'entrée/sortie (207, 207-VGC) chacun destiné à être optiquement couplé à un deuxième port optique d'entrée/sortie (11, 11-VGC) correspondant du circuit photonique.

## Description

### Domaine technique

La présente description concerne de façon générale les circuits photoniques intégrés (optiques et/ou optoélectroniques), et plus particulièrement le test des circuits photoniques intégrés.

### Technique antérieure

Des circuits photoniques intégrés sont couramment fabriqués à partir d'une tranche d'un matériau semiconducteur, ou tranche semiconductrice, qui est ensuite découpée pour obtenir une pluralité de puces individuelles. Avant l'étape de découpe, des tests sont effectués pour vérifier que les circuits sont fonctionnels.

Pour tester un circuit photonique intégré, des signaux optiques et/ou électriques sont fournis à des entrées du circuit. Des signaux optiques et/ou électriques correspondants sont observés au niveau de sorties du circuit pour déterminer si le fonctionnement du circuit est celui attendu ou non.

En raison du nombre élevé d'entrées et de sorties des circuits photoniques intégrés, le test d'un circuit photonique est complexe et long à mettre en oeuvre.

### Résumé de l'invention

Il existe un besoin d'un dispositif et/ou d'un procédé de test d'un circuit photonique intégré qui pallie tout ou partie des inconvénients des dispositifs et/ou des procédés connus de test d'un circuit photonique intégré.

Un mode de réalisation pallie tout ou partie des inconvénients des dispositifs et des procédés connus de test d'un circuit photonique intégré.

Un mode de réalisation prévoit un dispositif de test d'un circuit photonique, comprenant une puce photonique de test comportant, du côté d'une première face de la puce : des micro-piliers chacun destiné à être mis en contact avec un plot de connexion électrique correspondant du circuit photonique ; et des premiers ports optiques d'entrée/sortie chacun destiné à être optiquement couplé à un deuxième port optique d'entrée/sortie correspondant du circuit photonique.

Selon un mode de réalisation, un premier coupleur à réseau de diffraction verticale constitue un des premiers ports.

Selon un mode de réalisation, ledit premier coupleur est destiné à être optiquement couplé à un deuxième coupleur à réseau de diffraction verticale constituant un des deuxièmes ports.

Selon un mode de réalisation, la puce de test comprend une source d'un signal lumineux.

Selon un mode de réalisation, la source lumineuse est reliée optiquement à au moins un des premiers ports par l'intermédiaire d'au moins un guide d'onde de ladite puce de test.

Selon un mode de réalisation, chacun des premiers ports et des deuxièmes ports est un coupleur à réseau de diffraction verticale, une photodiode à illumination verticale ou une diode laser à cavité verticale émettant par la surface.

Selon un mode de réalisation, la puce de test comprend des plots de connexion électrique du côté d'une deuxième face opposée à la première face, et des vias traversants électriquement conducteurs reliant électriquement les micro-piliers auxdits plots.

Selon un mode de réalisation, le dispositif comprend en outre une carte de circuit imprimé disposée du côté de la deuxième face de la puce de test, la carte de circuit imprimé étant électriquement connectée aux plots de la puce de test.

Selon un mode de réalisation, le dispositif comprend un circuit de traitement configuré pour fournir des signaux électriques de test et recevoir des signaux électriques représentatifs du résultat du test.

Selon un mode de réalisation, la puce de test comprend le circuit de traitement.

Selon un mode de réalisation, le dispositif comprend une puce électronique comportant le circuit de traitement, dans lequel ladite puce électronique est intercalée entre la deuxième face de la puce de test et la carte de circuit imprimé et est connectée électriquement aux plots de la puce de test, ou dans lequel ladite puce électronique est montée sur la carte de circuit imprimé et est reliée aux plots de la puce de test par l'intermédiaire de la carte de circuit imprimé.

Selon un mode de réalisation, les premiers ports et les micro-piliers sont disposés sur la base des positions des deuxièmes ports et des plots de connexion du circuit photonique, de sorte que lorsque les micro-piliers sont en contact des plots du circuit photonique, les premiers ports sont optiquement couplés aux deuxièmes ports.

Selon un mode de réalisation, les micro-piliers ont une hauteur comprise entre 5 et 20 µm, un diamètre compris entre 5 et 20 µm, et sont de préférence revêtus d'un matériau élastique tel que de l'or.

Un autre mode de réalisation prévoit un procédé comprenant les étapes consistant à : a) prévoir un dispositif de test tel que défini ci-dessus et un circuit photonique à tester avec ledit dispositif, le circuit photonique comprenant un deuxième port de sortie et un deuxième port d'entrée connectés aux extrémités respectives d'un guide d'onde du circuit photonique, la puce de test comprenant un premier port de sortie destiné à être optiquement couplé au deuxième port d'entrée et un premier port d'entrée destiné à être couplé au deuxième port de sortie ; b) mettre la première face de la puce de test en vis-à-vis d'une face du circuit photonique du côté de laquelle sont disposés les deuxièmes ports ; et c) maximiser une quantité de lumière transmise du premier port de sortie au premier port d'entrée par l'intermédiaire du deuxième port d'entrée, du guide d'onde et du deuxième port de sortie.

Selon un mode de réalisation, le procédé comprend en outre, entre les étapes b) et c), une étape consistant à rendre parallèle la première face de la puce et ladite face du circuit photonique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, en vue en coupe et de manière très schématique, un mode de réalisation d'un circuit photonique intégré et un mode de réalisation d'un dispositif de test de ce circuit photonique intégré ;
la figure 2 est une vue en coupe schématique plus détaillée d'une portion du dispositif de test de la figure 1, selon un exemple de mode de réalisation ;
la figure 3 est une vue en coupe schématique plus détaillée d'une portion du circuit photonique de la figure 1, selon un exemple de mode de réalisation;
la figure 4 est une vue en coupe schématique représentant une variante de réalisation du dispositif de test de la figure 1 ;
la figure 5 illustre, de manière schématique et sous forme de blocs, un mode de réalisation d'un procédé de test du circuit de la figure 1 avec le dispositif de la figure 1 ou 4 ; et
la figure 6 illustre un mode de réalisation d'une étape du procédé de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la fabrication, le fonctionnement et le test (choix des signaux optiques et électriques de test et interprétation des signaux de sortie correspondants) des circuits intégrés photoniques n'ont pas été détaillés, les modes de réalisation décrits étant compatibles avec les circuits photoniques intégrés usuels.

Sauf précision contraire, lorsque l'on fait référence à deux éléments (électriquement ou optiquement) connectés entre eux, cela signifie directement connectés sans éléments intermédiaires autres que des conducteurs électriques ou des guides d'onde optiques, et lorsque l'on fait référence à deux éléments (électriquement ou optiquement) reliés entre eux, cela signifie que ces deux éléments peuvent être connectés ou être électriquement ou optiquement reliés par l'intermédiaire d'un ou plusieurs autres éléments. En outre, sauf précision contraire, lorsque l'on fait référence à deux ports d'entrée/sortie optiques optiquement couplés entre eux, cela signifie que ces ports d'entrée/sortie sont disposés de sorte qu'un signal optique puisse passer de l'un à l'autre de ces ports, autrement que par couplage évanescent ou couplage en champs proche, la distance entre les ports ainsi couplés pouvant alors être supérieure à une ou plusieurs fois la longueur d'onde du signal optique.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., sauf précision contraire, il est fait référence à l'orientation des figures.

Sauf précision contraire, les expressions "environ", "approximativement", "sensiblement", et "de l'ordre de" signifient à 10 % près, de préférence à 5 % près.

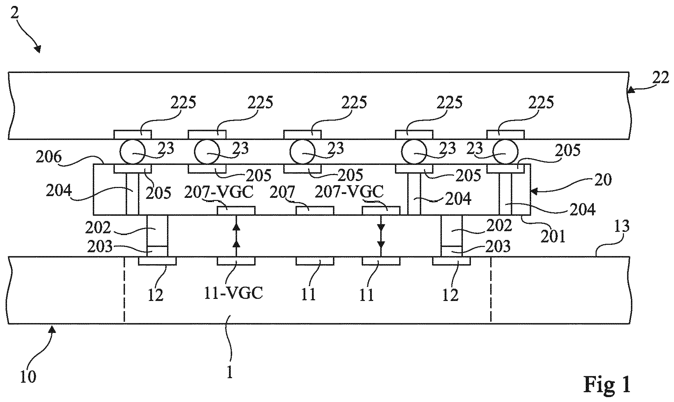

La figure 1 représente, en vue en coupe et de manière très schématique, un mode de réalisation d'un circuit photonique intégré 1 et un mode de réalisation d'un dispositif de test 2 du circuit 1.

Le dispositif de test 2 comprend une puce de circuit intégré photonique 20. La puce 20 comprend, du côté de sa face inférieure 201, des micro-piliers 202 électriquement conducteurs, par exemple en cuivre, destinés chacun à recevoir un signal électrique de sortie du circuit 1 ou à fournir un signal électrique d'entrée au circuit 1. A titre d'exemple, chaque signal électrique d'entrée du circuit 1 est un signal électrique d'alimentation ou un signal électrique de commande et/ou de test. De préférence, chaque micro-pilier 202 comprend un matériau conducteur élastique 203, par exemple de l'or, revêtant le micro-pilier 202 du côté opposé à la face 201. Autrement dit, l'extrémité du micro-pilier opposée à la face 201 est de préférence en le matériau 203.

De préférence, dans ce mode de réalisation, chaque micro-pilier 202 a une hauteur comprise entre 5 et 20 µm, la hauteur d'un micro-pilier étant par exemple mesurée perpendiculairement à la face 201. Comme cela se voit sur la figure 1 et se comprend par exemple de la suite de la description, les micro-piliers 202 ont de préférence tous la même hauteur, par exemple mesurée à partir de la face 201, perpendiculairement à cette dernière. Dit autrement, les extrémités opposées à la face 201 de tous les micro-piliers 202 sont comprises dans un même plan parallèle à la face 201 de la puce 20. De préférence, dans ce mode de réalisation, chaque micro-pilier 202 a une dimension latérale maximale, par exemple le diamètre pour un micro-pilier 202 sensiblement cylindrique, comprise entre 5 et 20 µm, cette dimension latérale étant par exemple mesurée dans un plan parallèle à la face 201. De préférence, la hauteur (ou épaisseur) du matériau 203 est comprise entre 2 et 10 µm, de préférence inférieure à 5 µm dans le cas de l'or.

La puce 20 comprend des vias 204 électriquement conducteurs, par exemple en cuivre, traversant tout ou partie de l'épaisseur de la puce 20. La puce 20 comprend en outre des plots de connexion électrique 205 disposés du côté de sa face supérieure 206. Les vias 204, couramment désignés par le sigle TSV (Through Silicon Via), relient électriquement les plots 205 aux micro-piliers 202, et, le cas échéant, à des composants électroniques et/ou optoélectroniques disposés du côté de la face 201 de la puce 20. Bien que cela ne soit pas visible en figure 1, de préférence la puce 20 comprend, du côté de sa face 201, une structure d'interconnexion comprenant au moins un niveau de métal pour connecter électriquement les vias 204 aux micro-piliers 202, et, le cas échéant, à des composants électroniques et/ou optoélectroniques disposés du côté de cette face 201. De manière similaire, de préférence la puce 20 comprend, du côté de sa face supérieure 206, une structure d'interconnexion comprenant au moins un niveau de métal pour connecter électriquement les vias 204 aux plots 205. A titre d'exemple, l'épaisseur de la puce 20, par exemple mesurée dans une direction orthogonale aux faces 201 et 206, est comprise entre 80 et 200 µm, par exemple de l'ordre de 100 µm.

La puce 20 comprend en outre, du côté de sa face inférieure 201, des ports optiques d'entrée/sortie 207. De préférence, au moins un port 207, référencé ci-après 207-VGC, est un coupleur à réseau de diffraction verticale (VGC-Vertical Grating Coupler). Comme cela se voit sur la figure 1 et se comprend par exemple de la suite de la description, tous les ports optiques 207-VGC appartiennent à un même plan parallèle à la face 201. Le fonctionnement d'un coupleur à réseau de diffraction verticale est basé sur des phénomènes de diffraction. A titre d'exemple, un coupleur à réseau de diffraction verticale occupe une surface d'environ 20 µm par environ 30 µm lorsque le faisceau lumineux reçu ou émis a un diamètre de l'ordre de 10 µm.

Dans cet exemple, la puce 20 comprend un port optique 207-VGC d'entrée (à gauche en figure 1) et un port optique 207-VGC de sortie (à droite en figure 1).

Le port 207-VGC d'entrée est configuré pour recevoir un signal optique sous la forme d'un faisceau lumineux (représenté par des flèches en figure 1) se propageant vers le port 207-VGC, dans une direction orthogonale ou sensiblement orthogonale à la face 201, par exemple avec un angle par rapport à la normale à la face 201 compris entre 0 et 45°, de préférence compris entre 0 et 15°, par exemple égal à 8°. Bien que cela ne soit pas visible en figure 1, de préférence, le port 207-VGC d'entrée est optiquement relié à une photodiode de la puce 20, par exemple par l'intermédiaire d'un guide d'onde de la puce 20. Ainsi, un signal optique reçu par le port 207-VGC d'entrée de la puce 20 peut être converti en un signal électrique correspondant par la photodiode.

Le port 207-VGC de sortie est configuré pour émettre un signal optique sous la forme d'un faisceau lumineux (représenté par des flèches en figure 1) se propageant depuis le port 207-VGC de sortie, dans une direction orthogonale ou sensiblement orthogonale à la face 201, par exemple avec un angle par rapport à la normale à la face 201 compris entre 0 et 45°, de préférence compris entre 0 et 15°, par exemple égal à 8°. Bien que cela ne soit pas visible en figure 1, le port 207-VGC de sortie est optiquement relié à une source de lumière de la puce 20, par exemple un laser, par exemple par l'intermédiaire d'un guide d'onde de la puce 20. Ainsi, un signal optique émis par le port 207-VGC de sortie de la puce 20 peut être fourni par cette source de lumière intégrée à la puce 20.

La puce 20 peut comprendre des ports optiques d'entrée/sortie autres que des coupleurs à réseau de diffraction verticale. Par exemple, au moins un port optique d'entrée 207 peut être une photodiode à illumination verticale et/ou au moins un port optique de sortie 207 peut être une source de lumière, par exemple une diode laser à cavité verticale émettant par la surface (VCSEL - Vertical Cavity Surface Emitting Laser), fournissant un faisceau lumineux se propageant dans une direction sensiblement perpendiculaire à la face 201.

Dans le mode de réalisation décrit, la puce 20 comprend donc au moins une source de lumière intégrée, par exemple une diode VCSEL utilisée directement comme port optique de sortie 207 et/ou un laser optiquement relié à un coupleur à réseau de diffraction verticale utilisé comme port optique de sortie 207-VGC, par exemple un laser de type DBR (de l'anglais Distributed Bragg Reflector laser) ou de type DFB (de l'anglais Distributed FeedBack laser), par exemple un laser comprenant des matériaux III-V situés dans les couches isolantes de la structure d'interconnexion du côté de la face 201, sous le niveau de métal supérieur en contact avec les micro-piliers 202, et un guide d'onde situé sous la structure d'interconnexion.

De préférence, comme cela est représenté en figure 1, le dispositif de test 2 comprend une carte de circuit imprimé 22, par exemple un substrat organique ou céramique muni d'un réseau d'interconnexion électrique, sur laquelle est montée la puce 20. Plus particulièrement, des plots 205 de la puce 20 sont électriquement connectés à des plots de connexion électrique 225 de la carte 22, ici disposés du côté de la face inférieure 221 de la carte 22. De préférence, pour chaque couple de plots 205 et 225 électriquement connectés l'un à l'autre, le plot 205 est en vis-à-vis du plot 225. La connexion électrique entre un plot 205 et un plot 225 est par exemple assurée par contact direct entre les deux plots ou par l'intermédiaire d'un élément de connexion électrique 23, par exemple une bille métallique ou un pilier métallique, s'étendant du plot 225 jusqu'au plot 205. A titre d'exemple, un élément de connexion électrique 23 peut être en un alliage d'étain, de cuivre et d'argent. Comme cela est représenté en figure 1, les éléments de connexion 23 peuvent ne pas être à l'aplomb d'un via 204, et être connectés électriquement à ces vias grâce à une structure d'interconnexion (non représentée) formée du côté de la face 206 de la puce 20.

La carte 22 fournit l'alimentation électrique à la puce 20. La carte 22 peut également fournir des signaux électriques de commande et/ou de test à la puce 20, par exemple des signaux à partir desquels la puce 20 génère des signaux électriques et/ou optiques de commande et/ou de test du circuit 1. La carte 22 peut également recevoir de la puce 20 des signaux électriques représentatifs de signaux électriques et/ou optiques reçus par la puce 20 depuis le circuit 1, c'est-à-dire des signaux représentatifs du résultat d'un test du circuit 1.

En figure 1, le circuit photonique intégré 1 fait partie d'une tranche semiconductrice 10 comprenant plusieurs circuits photoniques intégrés (délimités par des traits pointillés en figure 1), par exemple plusieurs circuits 1. Bien que cela ne soit pas représenté en figure 1, la tranche 10 repose sur une table mobile d'une station de test (non représentée), l'ensemble de la carte 22 et de la puce 20, étant porté par un bras mobile de la station de test 2, de préférence un bras mobile muni d'une liaison rotule permettant, le cas échéant, de compenser des défauts de planéité des faces 201 et/ou 13, par exemple en inclinant le plan de la face 201 par rapport au plan de la face 13. De préférence, la station de test fait partie du dispositif de test 2. Juste avant ou pendant une phase de test, chaque port optique 207 de la puce 20 est optiquement couplé à un port optique 11 correspondant du circuit 1, et chaque micro-pilier 202 de la puce 20 est en contact physique avec un plot de connexion électrique 12 (pads) correspondant du circuit 1, de sorte que ce micro-pilier 202 et ce plot 12 soient électriquement connectés.

Les plots de connexion électrique 12 sont disposés du côté de la face supérieure 13 du circuit 1, c'est-à-dire ici la face supérieure 13 de la tranche 10. Comme cela se voit sur la figure 1 et se comprend par exemple de la suite de la description, les plots 12 sont de préférence disposés dans un même plan parallèle à la face 13 du circuit à tester 1. Dit autrement, les faces exposées des plots 12 sont toutes disposées dans un même plan parallèle à la face 13 du circuit à tester 10. Chaque plot 12 est destiné à recevoir un signal électrique d'entrée du circuit 1 ou à fournir un signal électrique de sortie du circuit 1. A titre d'exemple, chaque signal électrique d'entrée du circuit est un signal électrique d'alimentation ou un signal électrique de commande et/ou de test. Bien que cela ne soit pas visible en figure 1, de préférence le circuit 1 comprend, du côté de sa face 13, une structure d'interconnexion comportant au moins un niveau de métal, de manière à connecter électriquement les plots 12 à des composants actifs (optoélectroniques et/ou électroniques) disposés du côté de cette face 13.

A titre d'exemple, pour les exemples de dimensions de micro-pilier indiquées précédemment, la surface de chaque plot 12 est inférieure à 25 µm^{∗}25 µm, de préférence inférieure à 15 µm^{∗}15 µm, par exemple de l'ordre de 5 µm^{∗}5 µm, de préférence égale à 5 µm^{∗}5 µm.

Les ports optiques 11 d'entrée/sortie du circuit 1 sont également disposés du côté de la face supérieure 13 du circuit 1. De préférence, au moins un port 11 est un coupleur à réseau de diffraction verticale, référencé 11-VGC dans la suite de la description. Chaque port optique 11-VGC peut être un port d'entrée ou un port de sortie du circuit 1. De préférence, lors d'une phase de test du circuit 1, au moins un port 11-VGC est optiquement couplé à un port 207-VGC comme cela est représenté à gauche en figure 1, ou, autrement dit, au moins un port 207-VGC est destiné à être optiquement couplé à un port 11-VGC. De préférence, tous les ports optiques 11-VGC appartiennent à un même plan parallèle à la face 13 du circuit 1.

Le circuit 1 peut comprendre des ports optiques 11 d'entrée/sortie autres que des coupleurs à réseau de diffraction verticale. Par exemple, au moins un port optique d'entrée du circuit 1 peut être une photodiode à illumination verticale et/ou au moins un port optique de sortie du circuit 1 peut être une source de lumière, par exemple une diode VCSEL, fournissant un faisceau lumineux dirigé sensiblement perpendiculairement par rapport à la face 13.

Dans le mode de réalisation de la figure 1, l'utilisation de micro-piliers 202 pour échanger des signaux électriques entre la puce 20 et le circuit 1 permet que les plots 12 aient des dimensions plus faibles que si ces signaux avaient été échangés par l'intermédiaire de pointes de test ("test probe points" en anglais) en contact physique et électrique avec les plots 12.

En outre, l'utilisation de micro-piliers 202 permet que, lors du test, les faces 201 et 13 en vis-à-vis l'une de l'autre soient suffisamment proches pour que les ports optiques 207 de la puce 20 soient optiquement couplés aux ports optiques 11 du circuit sans recourir à des dispositifs optiques complexes de focalisation et/ou d'orientation de la lumière tels que des prismes ou des lentilles. Cela est en particulier vrai lors du couplage d'un port 207-VGC avec un port 12-VGC, un tel couplage pouvant par exemple intervenir jusqu'à une distance de 100 µm environ entre ces deux ports, bien qu'une distance inférieure ou égale à 20 µm environ, compatible avec la hauteur des micro-piliers 202, soit préférée pour limiter les pertes dues à la divergence du faisceau se propageant entre ces deux ports. De préférence, la distance entre le plan comprenant le ou les ports optiques 207 et le plan comprenant les extrémités des micro-piliers 202 opposées à la face 201 est inférieure ou égale à 100 µm, voire inférieure ou égale à 20 µm. De manière similaire, la distance entre le plan comprenant le ou les ports optiques 11-VGC et le plan comprenant les plots 203 est inférieure ou égale à 5 µm, voire à 1 µm. Bien que la hauteur des micro-piliers 202 rende difficile, voire impossible, un couplage évanescent, ou couplage en champ proche, entre deux ports 207 et 11, cela n'est pas gênant puisque ce type de couplage optique n'est pas celui qui est utilisé ici.

Dans le mode de réalisation décrit, la prévision d'au moins une source de lumière intégrée à la puce 20 permet de fournir des signaux optiques d'entrée au circuit 1 sans recours à une source de lumière extérieure à la puce 20 qui serait optiquement reliée à la puce 20 par l'intermédiaire d'une fibre optique. Cela permet donc de s'affranchir d'une étape complexe de fixation d'une fibre à la puce 20 et/ou d'alignement d'une extrémité d'une fibre avec un port optique de la puce 20, typiquement une fibre monomode à maintien de polarisation. En outre, le diamètre d'une fibre optique étant couramment supérieure à 80 µm, voire à 125 µm, l'espace disponible entre les faces 201 et 13 lors d'une phase de test du circuit 1 ne permet pas de mettre en vis-à-vis l'extrémité d'une telle fibre optique avec un port optique de la puce 20 disposé du côté de sa face 201, la prévision de la carte de circuit imprimée 22 ne permet pas de mettre en vis-à-vis l'extrémité d'une telle fibre optique avec un port optique de la puce 20 disposé du côté de sa face supérieure 206, et l'espace disponible entre les faces 13 et 201 lors d'une phase de test du circuit rend difficile, voire impossible, la mise en vis-à-vis de l'extrémité d'une telle fibre optique avec un port optique de la puce 20 qui serait disposé sur une face latérale de la puce 20 (couplage par la tranche).

La prévision de vias 204 permet que des signaux électriques, notamment l'alimentation électrique de la puce 20, soient fournis à la puce 20 du côté de sa face 206. Les vias 204 permettent également, le cas échéant, que des signaux électriques, par exemple représentatifs d'un test du circuit 1, soient fournis par la puce 20 du côté de sa face 206 au niveau de plots 205. On aurait pu penser échanger ces signaux électriques avec la puce 20 par l'intermédiaire de fils conducteurs connectés directement à des plots métalliques disposés du côté de la face 201 de la puce 20 (wire bounding) . Toutefois, cela aurait été difficilement réalisable, voire impossible, en raison du faible espace disponible entre les faces 201 et 13 lors d'une phase de test.

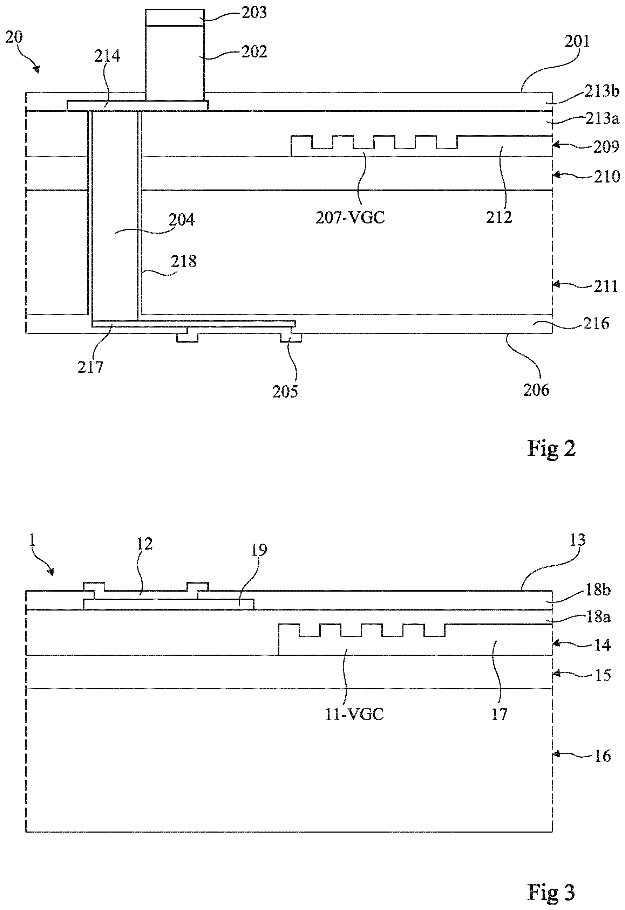

La figure 2 est une vue en coupe schématique plus détaillée d'une portion de la puce 20 du dispositif de test 2 de la figure 1, selon un exemple de mode de réalisation. Par rapport à la figure 1, la puce 20 a été retournée, les faces 201 et 206 de la puce 20 correspondant respectivement aux faces supérieure et inférieure de la puce 20 en figure 2.

Dans ce mode de réalisation, la puce 20 comprend une couche de silicium 209 reposant sur une couche isolante 210, par exemple d'oxyde de silicium, reposant elle-même sur un substrat semiconducteur 211, par exemple en silicium. La couche 209 est dite de type SOI (Silicon On Insulator).

Divers éléments intégrés photoniques (optiques et optoélectroniques) et, le cas échéants, électroniques, sont formés dans et/ou sur la couche 209. A titre d'exemple, ces éléments peuvent être des lasers, des photodiodes, des coupleurs, des séparateurs, des modulateurs, des guides d'onde, des coupleurs à réseau de diffraction verticale, etc. Dans l'exemple de la figure 2, un port optique 207-VGC et un guide de d'onde 212 sont définis dans la couche 209, le port 207-VGC étant disposé à une extrémité du guide d'onde 212. La réalisation de ces divers éléments par des étapes de masquage, de gravure, de dopage, etc. de la couche 209 est à la portée de l'homme de métier. De préférence, tous les ports optiques 207-VGC sont définis dans la couche 209. Dit autrement, tous les ports optiques 207-VGC appartiennent à un même plan parallèle à la face 201 de la puce 20.

La couche 209 est revêtue d'une ou plusieurs couches isolantes 213, dans cet exemple une couche d'oxyde de silicium 213a recouvrant la couche 209 et une couche 213b de nitrure de silicium reposant sur la couche 213a. Les couches 210 et 213a, de préférence en le même matériau, constitue un milieu d'indice de réfraction plus faible que celui du silicium de la couche 209, et jouent le rôle de gaine optique d'indice faible. Des portions de couche métallique 214, noyées dans les couches isolantes 213, forment la structure d'interconnexion du côté de la face 201 de la puce 20. Dans cet exemple, la structure d'interconnexion comprend un unique niveau de métal constitué des portions de couche métallique 214 reposant sur la couche isolante 213a et recouvertes de la couche isolante 213b. Dans l'exemple représenté en figure 2, un micro-pilier 202 repose sur une portion de couche métallique 214, elle-même en contact avec un via 204, le micro-pilier 202 et le via 204 étant ainsi connectés électriquement l'un à l'autre. En outre, bien que cela ne soit pas représenté en figure 2, une portion de couche métallique 214 de la structure d'interconnexion peut être électriquement connectée à un composant actif de la couche 209, par l'intermédiaire d'un via conducteur s'étendant depuis cette portion de couche métallique 214 jusqu'à une borne de connexion du composant formée sur et/ou dans la couche 209.

La puce 20 comprend, du côté de sa face 206, une ou plusieurs couches isolantes 216 reposant sur la face du substrat 211 opposée à la couche 209. Des portions de couche métallique 217 noyées dans les couches isolantes 216 forment la structure d'interconnexion du côté de la face 206 de la puce 20. Dans cet exemple, la structure d'interconnexion comprend un unique niveau de métal constitué des portions de couche métallique 217.

Chaque plot 205, un seul plot 205 étant représenté en figure 2, est formé au niveau de la face libre de la structure d'interconnexion disposée du côté de la face 206 et est au moins en partie en contact avec une portion de couche métallique 217 de manière à être électriquement connecté à un via 204. A titre d'exemple, la couche 217 est en cuivre ou en aluminium, les plots 205 en contact de la couche 217 étant par exemple en aluminium.

En variante, un plot 205 peut correspondre à une partie d'une portion de couche métallique 217 dont la surface est exposée.

Comme cela est représenté en figure 2, le via conducteur traversant 204 est de préférence entouré latéralement par une gaine isolante 218 l'isolant électriquement du substrat 211 et, le cas échéant, de la couche 209.

Dans des variantes de réalisation non représentées, le nombre et/ou les matériaux des couches isolantes 213, 216, le nombre de niveaux de métal de chaque structure d'interconnexion de la puce 20, et la disposition d'au moins certains composants optiques et/ou optoélectroniques (guide d'onde, coupleur à réseau de diffraction verticale, etc..) pourront être adaptés par l'homme du métier. En particulier, on peut prévoir que la structure d'interconnexion du côté de la face 201 de la puce 20 comprenne plus d'un niveau de métal reliés entre eux par des vias conducteurs traversant des couches isolantes de la structure d'interconnexion. Dans ce cas, on peut prévoir que des guides d'onde et/ou des coupleurs à réseau de diffraction verticale, par exemple en nitrure de silicium noyé dans de l'oxyde de silicium, soient formés directement dans les couches isolantes de la structure d'interconnexion. Dans ce cas, on peut également prévoir un laser comprenant d'une part des puits quantiques en matériaux III-V disposés dans des couches isolantes de la structure d'interconnexion intercalées entre la couche 213a et la couche 213b, et d'autre part un guide d'onde et un ou plusieurs réseaux de Bragg situés au moins en partie dans la couche 209.

La figure 3 est une vue en coupe schématique plus détaillée d'une portion du circuit photonique 1 de la figure 1, selon un exemple de mode de réalisation.

Dans ce mode de réalisation, le circuit 1 comprend une couche de silicium 14 reposant sur une couche isolante 15, par exemple d'oxyde de silicium, reposant elle-même sur un substrat semiconducteur 16, par exemple en silicium, la couche 14 étant dite de type SOI.

De manière similaire à ce qui a été décrit en relation avec la figure 2, divers éléments intégrés photoniques (optiques et optoélectroniques) et, le cas échéants, électroniques, sont formés dans et/ou sur la couche 14. Dans l'exemple de la figure 3, un port optique 11-VGC et un guide de d'onde 17 sont définis dans la couche 14, le port 11-VGC étant disposé à une extrémité du guide d'onde 17. De préférence, tous les ports optiques 11-VGC sont définis dans la couche 14. Dit autrement, tous les ports optiques 11-VGC appartiennent à un même plan parallèle à la face 13 du circuit 1.

La couche 14 est revêtue d'une ou plusieurs couches isolantes 18, dans cet exemple une couche d'oxyde de silicium 18a recouvrant la couche 14 et une couche 18b de nitrure de silicium reposant sur la couche 18a. Des portions de couche métallique 19, noyées dans les couches isolantes 18, constituent la structure d'interconnexion. Dans cet exemple, la structure d'interconnexion comprend un unique niveau de métal constitué des portions de couche métallique 19 reposant sur la couche isolante 18a et recouvertes de la couche isolante 18b.

Chaque plot 12, un seul plot 12 étant représenté en figure 3, est formé au niveau de la face libre de la structure d'interconnexion disposée du côté de la face 13 et est au moins en partie sur et en contact avec une portion de couche métallique 19 de manière à être électriquement connecté à des composants actifs (optoélectroniques et/ou électroniques) formés dans et/ou sur la couche 14. Par exemple, bien que cela ne soit pas visible en figure 3, la portion de couche métallique 19 en contact avec le plot 12 est reliée à une borne de connexion électrique d'un composant actif du circuit 1 par l'intermédiaire d'un via conducteur s'étendant depuis cette portion de couche métallique 19 jusqu'à la borne de connexion. A titre d'exemple, la couche 19 est en cuivre ou en aluminium, le plot 12 disposé sur et en contact avec la couche 19 étant par exemple en aluminium.

En variante, un plot métallique 12 peut correspondre à une partie d'une portion de couche métallique 19 dont la surface est exposée.

De manière similaire à la puce 20, le circuit 1 peut être adapté par l'homme de métier, notamment en ce qui concerne le nombre et/ou les matériaux des couches isolantes et/ou des niveaux de métal de la structure d'interconnexion, ou encore en ce qui concerne la disposition de composants du circuit 1 tels que des guides d'onde, des coupleurs à réseau de diffraction verticale ou des lasers.

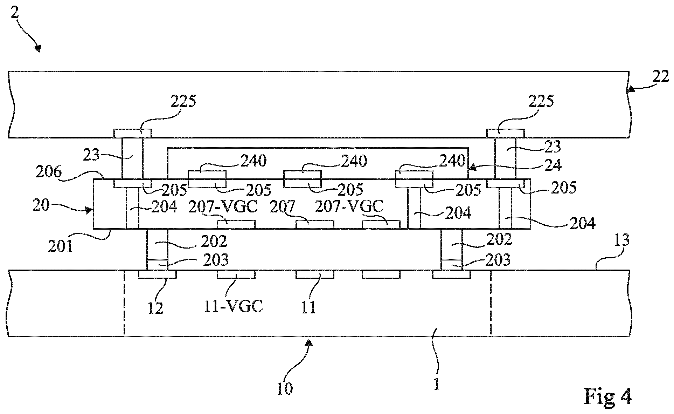

La figure 4 est une vue en coupe schématique représentant une variante de réalisation du dispositif de test de la figure 1.

Dans cette variante, on prévoit que la puce 20 soit associée à une puce de circuits intégrés électroniques 24. La puce électronique 24 permet de réaliser des opérations logiques sur des signaux électriques qu'elle reçoit de la puce 20 et/ou permet de fournir des signaux de test, ou vecteur de test, à la puce 20 de manière à mettre en oeuvre un test du circuit 1. A titre d'exemple, la puce 24 est une puce dédiée (ASIC) ou une puce configurable ou programmable, par exemple de type FPGA.

Ainsi, dans la variante de réalisation de la figure 4, le dispositif 2 diffère de celui de la figure 1 uniquement en ce qu'il comprend la puce 24.

La puce 24 est ici disposée du côté de la face supérieure 206 de la puce 20. Les éléments de connexion 23, ici des piliers conducteurs électriquement, sont choisis pour permettre une telle disposition.

La puce 24 est connectée électriquement à la puce 20. Plus particulièrement, dans l'exemple représenté, la puce 24 comprend des plots de connexion électrique 240 disposés du côté de sa face inférieure 241, chaque plot 240 étant connecté à un plot 205 correspondant. Dans cet exemple, chaque plot 240 est connecté à un plot 205 par contact direct. En variante, des éléments de connexion électriques, par exemple des billes conductrices ou des piliers conducteurs, peuvent être prévus entre les plots 240 et les plots 205 correspondants.

Dans cette variante de réalisation, la puce 24 est alimentée en électricité par la puce 20, elle-même alimentée en électricité par la carte 22.

Dans une autre variante de réalisation non illustrée, la puce 24 est montée sur la carte de circuit imprimé 22 plutôt que sur la puce 20 comme cela est représenté en figure 4. La puce 24 est alors électriquement reliée à la puce 20 par l'intermédiaire de la carte 22. Dans cette autre variante, la puce 24 peut être alimentée en électricité directement par la carte 22.

On notera que la variante de réalisation de la figure 4 permet, par rapport au cas où la puce 24 est montée sur la carte 22, de réduire la longueur des chemins électriques empruntés par les signaux électriques échangés entre les puces 20 et 24, ce qui est notamment intéressant quand ces signaux sont des signaux hautes fréquences, c'est-à-dire à des fréquences supérieures à 10 GHz.

La prévision de la puce 24 associée à la puce 20 permet de commander localement la puce 20 pour qu'elle fournisse les signaux de test (optiques et/ou électriques) au circuit 1. La prévision de la puce 24 associée à la puce 20 permet également lorsque la puce 20 reçoit les signaux de sortie (optiques et/ou électriques) du circuit 1, les signaux optiques reçus étant éventuellement convertis en signaux électriques par la puce 20, de traiter ces signaux électriques pour déterminer si le circuit 1 fonctionne ou non correctement.

Par exemple, on considère le cas où le circuit 1 comprend un laser et un modulateur électro-optique. Lors d'une phase de test du circuit 1, la puce 20 alimente en électricité le circuit 1, et en particulier le laser du circuit 1, par l'intermédiaire de la connexion électrique entre les micro-piliers 202 de la puce 20 et les plots 12 du circuit 1. En outre, la puce 20 fournit un ou plusieurs signaux électriques de test, et en particulier un signal de commande du modulateur du circuit 1, toujours par l'intermédiaire de la connexion électrique entre les micro-piliers 202 et les plots 12. Le signal laser modulé est émis par le circuit 1, par exemple par un port optique de sortie 11-VGC, en direction d'un port optique 207 correspondant de la puce 20, par exemple une photodiode à illumination verticale ou un coupleur à réseau de diffraction verticale 207-VGC relié optiquement à une photodiode. Le signal électrique de sortie de la photodiode est alors fourni à la puce 24, soit directement quand la puce 24 est montée sur la puce 20, soit par l'intermédiaire de la carte 22 lorsque la puce 24 est montée sur cette carte. La puce 24 en déduit alors si le fonctionnement de l'ensemble du laser et du modulateur du circuit 1 est correct ou non.

Dans une autre variante de réalisation non illustrée, on peut prévoir que la puce 20 comprenne un circuit électronique mettant en oeuvre les fonctions de la puce 24, la puce 24 pouvant alors être omise.

Dans encore une autre variante de réalisation non illustrée, la puce 20 transmet à la station de test, par exemple à une unité de traitement de la station de test, des informations représentatives des signaux qu'elle reçoit du circuit 1, et la station de test détermine alors, sur la base de ces informations, si le circuit est fonctionnel.

Pour échanger des informations avec la station de test, par exemple une information représentative du résultat d'un test du circuit 1, l'ensemble de la puce 20 et de la carte 22, éventuellement muni de la puce 24, peut recourir à une liaison filaire, par exemple à un bus connecté entre la carte 22 et la station de test. En variante, ces informations peuvent être échangées par liaison sans-fil, la carte 22, la puce 20 et/ou la puce 24 étant alors munies d'antennes pour assurer cette liaison sans-fil.

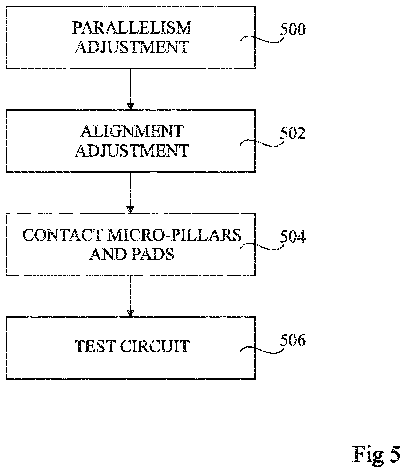

La figure 5 illustre, de manière schématique et sous forme de blocs, un mode de réalisation d'un procédé de test du circuit 1 avec le dispositif 2.

A une première étape 500 (PARALLELISM ADJUSTMENT), la tranche 10 est disposée sur la table mobile de la station de test du dispositif 2, et l'ensemble de la carte 22 et de la puce 20, éventuellement muni de la puce 24, est disposé sur un bras mobile de la station de test de sorte que la face 201 de la puce 20 soit en vis-à-vis de la face 13 de la tranche 10. La face 201 est rendue parallèle à la face 13 en déplaçant l'un par rapport à l'autre la table et le bras de la station de test. A titre d'exemple, ce réglage du parallélisme est mis en oeuvre grâce à la méthode décrite dans la demande de brevet français N°3063833.

Cette étape peut être mise en oeuvre de manière automatique par le dispositif 2, par exemple grâce à des instructions stockées dans une mémoire de la station de test qui, lorsqu'elles sont lues par la station de test, par exemple par une unité de traitement de la station de test, entraînent la mise en oeuvre de l'étape 500. Par exemple, la station de test peut recevoir des signaux représentatifs de l'orientation courante de la face 201 par rapport à la face 13, et en déduire des signaux de commande du déplacement l'un par rapport à l'autre de la table et du bras de la station de test jusqu'à ce que les faces 201 et 13 soient parallèles entre elles.

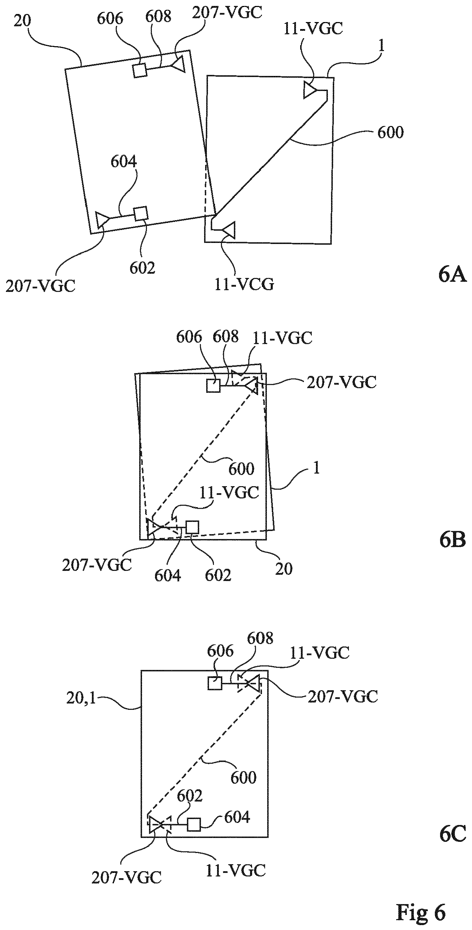

A une étape suivante 502 (ALIGNMENT ADJUSTMENT), la puce 20 et le circuit 1 sont alignés, c'est-à-dire mis en vis-à-vis de sorte que chaque micro-pilier 202 de la puce 20 soit en vis-à-vis d'un plot 12 correspondant du circuit 1 et que chaque port optique 207 soit aligné avec un port optique 11 correspondant, éventuellement en tenant compte de l'angle avec lequel un signal optique est transmis de l'un à l'autre de ces ports. Pour cela, le bras et la table mobile de la station de test sont par exemple déplacés l'un par rapport à l'autre dans des directions parallèles aux faces 201 et 13, et éventuellement en rotation autour d'un axe orthogonal à ces faces 201 et 13. Un exemple de mode de réalisation d'une telle étape sera décrit en détail en relation avec la figure 6.

Cette étape peut être mise en oeuvre de manière automatique par le dispositif 2, par exemple grâce à des instructions stockées dans une mémoire de la station de test qui, lorsqu'elles sont lues par la station de test, par exemple par une unité de traitement de la station de test, entraînent la mise en oeuvre de l'étape 502. Par exemple, la station de test peut recevoir des signaux représentatifs de l'orientation courante de la face 201 par rapport à la face 13, et en déduire des signaux de commande du déplacement l'un par rapport à l'autre de la table et du bras de la station de test jusqu'à ce que la puce 20 et le circuit 1 soient alignés.

A une étape suivante 504 (CONTACT MICRO-PILLARS AND PADS), les faces 201 et 13 sont rapprochées l'une de l'autre, sans modifier le parallélisme entre ces faces, jusqu'à ce que chaque micro-pilier 202 soit en contact d'un plot 12 correspondant. Lors de cette étape, le matériau 203 et/ou la rotule du bras mobile de la station permettent de compenser d'éventuels défauts de planéité des faces 201 et 13. Une fois que les micro-piliers 202 sont en contact des plots 12 correspondants, les ports optiques 207 sont couplés optiquement aux ports optiques 11 correspondants.

Cette étape peut être mise en oeuvre de manière automatique par le dispositif 2, par exemple grâce à des instructions stockées dans une mémoire de la station de test qui, lorsqu'elles sont lues par la station de test, par exemple par une unité de traitement de la station de test, entraînent la mise en oeuvre de l'étape 504. Par exemple, la station de test peut recevoir des signaux représentatifs de l'orientation courante de la face 201 par rapport à la face 13, et en déduire des signaux de commande du déplacement l'un par rapport à l'autre de la table et du bras de la station de test jusqu'à ce les micro-piliers 202 soient en contact des plots 12 correspondants.

A une étape suivante 506 (TEST CIRCUIT), le circuit 1 est testé grâce à l'alimentation électrique et aux signaux optiques et/ou électriques qu'il reçoit de la puce 20. La puce 20 reçoit en retour des signaux de sortie optiques et/ou électriques du circuit 1. A partir de ces signaux de sortie du circuit 1, la puce 24, la puce 20 et/ou la station de test selon le cas, déterminent si circuit 1 est fonctionnel.

Cette étape peut être mise en oeuvre de manière automatique par le dispositif 2, par exemple grâce à des instructions stockées dans une mémoire de la station de test et/ou dans une mémoire de la puce 24 et/ou dans une mémoire de la puce 20 qui, lorsqu'elles sont lues par une unité de traitement de la station de test et/ou de la puce 22 et/ou de la puce 24 entraînent la mise en oeuvre de l'étape 506.

Les étapes 502 à 506 peuvent être répétées pour tester chaque circuit 1 de la tranche 10. En particulier, une fois que l'étape 502 a été mise en oeuvre une première fois pour un premier circuit 1 de la tranche, lors des étapes 502 ultérieures, l'alignement de la puce 20 sur un autre circuit 1 peut être effectuée sur la base d'un décalage connu entre cet autre circuit et le premier circuit testé, par exemple en déplaçant la puce 20 et la tranche 10 l'une par rapport à l'autre sur la base de ce décalage, de préférence uniquement dans des directions parallèles et orthogonales aux plans des faces 201 et 13, c'est-à-dire sans modifier l'inclinaison des faces 201 et 13 l'une par rapport à l'autre.

En outre, bien que cela ne soit pas illustré ici, on prévoit des étapes préalables de conception et de fabrication de la puce 20, et, le cas échéant, de la carte 22 et/ou de la puce 24, ainsi qu'une étape d'assemblage de ces éléments 20, 22 et 24. L'homme du métier est en mesure de mettre en oeuvre ces étapes, en particulier, l'homme du métier est en mesure de déterminer la position des micro-piliers 202 et des ports optique 207 de la puce 20 à partir de la position connue des plots 12 et des ports optiques 11 du circuit 1.

La figure 6 illustre un mode de réalisation de l'étape 502 du procédé de la figure 5. Plus particulièrement, la figure 6 représente des vues 6A, 6B et 6C de dessus de la puce 20 disposée au-dessus du circuit 1, ces vues illustrant des étapes successives de l'étape 502.

Dans ce mode de réalisation, on prévoit que le circuit 1 comprenne un guide d'onde 600, et un port 11-VGC à chacune des extrémités du guide d'onde 600. De préférence, les ports 11-VGC connectés optiquement au guide d'onde 600 sont disposés dans des coins opposés du circuit 1. On prévoit en outre que la puce 20 comprenne deux ports optiques 207 destinés à être optiquement couplés aux ports 11-VGC. L'un de ces deux ports 207 est un port de sortie de la puce 20, l'autre étant un port d'entrée de la puce 20. Dans cet exemple, le port de sortie est un port 207-VGC optiquement connecté à un laser 602 de la puce 20 par un guide d'onde 604 de la puce 20, le port d'entrée étant un port 207-VGC optiquement connecté à une photodiode 606 de la puce 20 par un guide d'onde 608 de la puce 20.

A l'étape illustrée par la vue 6A de la figure 6, la puce 20 et le circuit 1 ne sont pas alignés et les ports 207-VGC ne sont pas alignés avec les ports 11-VGC correspondants.

A l'étape suivante illustrée par la vue 6B de la figure 6, un alignement grossier a été effectué, par exemple en alignant les bords de la puce 20 ou de la carte 22 avec un repère de la tranche 10 comprenant le circuit 1, de sorte qu'un couplage optique s'établisse entre les ports 207 et les ports 11-VGC. L'établissement de ce couplage optique peut par exemple être détecté lorsque que le port 207 de sortie fournit un signal optique au port 11-VGC correspondant et que le port 207 d'entrée reçoit un signal optique en provenance du port 11-VGC correspondant. A titre d'exemple, pour qu'un couplage puisse être détecté, la distance entre les deux faces 201 et 13 est inférieure ou égale à 100 µm, voire inférieure à 50 µm. Cette distance est suffisante pour permettre de déplacer l'un par rapport à l'autre la puce 20 et le circuit 1 dans des directions parallèles aux faces 201 et 13, et éventuellement en rotation autour d'un axe orthogonal à ces faces 201 et 13, sans que les micro-piliers 202, éventuellement munis du matériau 203, ne soient en contact avec la face 13.

A l'étape suivante illustrée par la vue 6C de la figure 6, un alignement fin a été effectué, en déplaçant la puce 20 et le circuit 1 l'un par rapport à l'autre jusqu'à maximiser la puissance optique reçue par le port 207 d'entrée de la puce 20, et plus particulièrement jusqu'à maximiser la puissance optique transmise, par l'intermédiaire du circuit 1, du port 207-VGC de sortie de la puce 20 vers le port 207-VGC d'entrée de la puce. L'alignement est alors terminé.

On notera que l'étape d'alignement grossier décrite en relation avec la vue 6B de la figure 6, et éventuellement l'étape d'alignement fin de la vue 6C de la figure 6, peuvent être omises lors de répétitions de l'étape 502. Par exemple, lors de répétition de l'étape 502, plutôt que de répéter les étapes décrites en relation avec la figure 6, l'étape 502 est effectuée en déplaçant la puce 20 et la tranche 10 l'une par rapport à l'autre dans des directions et sur des distances connues correspondant au décalage entre deux circuits 1. On peut alors prévoir qu'un seul circuit 1 de la tranche 10 soit du type de celui décrit en relation avec la figure 6, voire on peut prévoir un circuit 1 dédié à l'étape 502 telle que décrite en relation avec la figure 6.

Bien que le circuit 1 et la puce 20 sont représentés en figure 6 comme ayant les mêmes dimensions, le procédé décrit en relation avec la figure 6 s'applique également au cas où ils ont des dimensions différentes.

La mise en oeuvre des modes de réalisation décrits en relation avec les figures 1 à 6 permet d'obtenir un positionnement des ports 207 et des micro-piliers 202 de la puce 20 par rapport respectivement aux ports 11 et aux plots 12 du circuit 1 avec une précision de moins de 2 µm, voire de moins de 1 µm.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que l'on ait décrit le cas où un circuit 1 correspond, une fois la tranche 10 découpée, à une puce de circuits photoniques intégrés, ce qui a été décrit s'applique au cas où le circuit 1 correspond à plusieurs circuits photoniques, de sorte qu'une fois la tranche découpée, plusieurs puces de circuits photoniques intégrés sont obtenues à partir d'un même circuit 1. Le test simultané de plusieurs circuits photoniques intégrés à l'aide d'une seule puce 20 permet de réduire le temps nécessaire pour tester tous les circuits photoniques de la tranche 10.

Enfin, la mise en oeuvre pratique des modes de réalisation et variantes décrits est à la portée de l'homme du métier à partir des indications fonctionnelles données ci-dessus.

## Revendications

1. Dispositif de test (2) d'un circuit photonique (1) faisant partie d'une tranche semiconductrice, comprenant une puce photonique de test (20) comportant, du côté d'une première face (201) de la puce :
des micro-piliers (202) chacun destiné à être mis en contact avec un plot de connexion électrique (12) correspondant du circuit photonique ; et
des premiers ports optiques d'entrée/sortie (207, 207-VGC) chacun destiné à être optiquement couplé à un deuxième port optique d'entrée/sortie (11, 11-VGC) correspondant du circuit photonique.

2. Dispositif selon la revendication 1, dans lequel un premier coupleur à réseau de diffraction verticale (207-VGC) constitue un des premiers ports (207).

3. Dispositif selon la revendication 2, dans lequel ledit premier coupleur (207-VGC) est destiné à être optiquement couplé à un deuxième coupleur à réseau de diffraction verticale (12-VGC) constituant un des deuxièmes ports (11).

4. Dispositif selon l'une quelconque des revendications 1 à 3, dans lequel les micro-piliers (202) ont une hauteur comprise entre 5 et 20 µm, de préférence identique pour tous les micro-piliers (202).

5. Dispositif selon l'une quelconque des revendications 1 à 4, comprenant en outre une station de test, la station de test comportant :
une table mobile destinée à recevoir la tranche semiconductrice ; et
un bras mobile destiné à porter la puce de test.

6. Dispositif selon l'une quelconque des revendications 1 à 5, dans lequel la puce de test (20) comprend une source (602) d'un signal lumineux.

7. Dispositif selon la revendication 6, dans lequel la source lumineuse est reliée optiquement à au moins un des premiers ports (207-VGC) par l'intermédiaire d'au moins un guide d'onde (604) de ladite puce de test (20).

8. Dispositif selon l'une quelconque des revendications 1 à 7, dans lequel chacun des premiers ports (207, 207-VGC) et des deuxièmes ports (11, 11-VGC) est un coupleur à réseau de diffraction verticale, une photodiode à illumination verticale ou une diode laser à cavité verticale émettant par la surface.

9. Dispositif selon l'une quelconque des revendications 1 à 8, dans lequel la puce de test comprend des plots de connexion électrique (205) du côté d'une deuxième face (206) opposée à la première face (201), et des vias traversants électriquement conducteurs (204) reliant électriquement les micro-piliers (202) auxdits plots.

10. Dispositif selon la revendication 9, comprenant en outre une carte de circuit imprimé (22) disposée du côté de la deuxième face (206) de la puce de test (20), la carte de circuit imprimé étant électriquement connectée aux plots (205) de la puce de test (20).

11. Dispositif selon l'une quelconque des revendications 1 à 10, comprenant un circuit de traitement configuré pour fournir des signaux électriques de test et recevoir des signaux électriques représentatifs du résultat du test.

12. Dispositif selon la revendication 11, dans lequel la puce de test (20) comprend le circuit de traitement.

13. Dispositif selon les revendications 10 et 11, comprenant une puce électronique (24) comportant le circuit de traitement, dans lequel ladite puce électronique (24) est intercalée entre la deuxième face (206) de la puce de test (20) et la carte de circuit imprimé (22) et est connectée électriquement aux plots (205) de la puce de test (20), ou dans lequel ladite puce électronique (24) est montée sur la carte de circuit imprimé (22) et est reliée aux plots (205) de la puce de test (20) par l'intermédiaire de la carte de circuit imprimé.

14. Dispositif selon l'une quelconque des revendications 1 à 13, dans lequel les premiers ports (207, 207-VGC) et les micro-piliers (202) sont disposés sur la base des positions des deuxièmes ports (11, 11-VGC) et des plots de connexion (12) du circuit photonique (1), de sorte que lorsque les micro-piliers (202) sont en contact des plots (12) du circuit photonique (1), les premiers ports (207, 207-VGC) sont optiquement couplés aux deuxièmes ports (11, 11-VGC).

15. Dispositif selon l'une quelconque des revendications 1 à 14, dans lequel les micro-piliers (202) ont un diamètre compris entre 5 et 20 µm, et sont de préférence revêtus d'un matériau élastique (203) tel que de l'or.

16. Procédé comprenant les étapes consistant à :
a) prévoir un dispositif de test (2) selon l'une quelconque des revendications 1 à 13 et un circuit photonique (1) à tester avec ledit dispositif, le circuit photonique comprenant un deuxième port de sortie (12-VGC) et un deuxième port d'entrée (12-VGC) connectés aux extrémités respectives d'un guide d'onde (600) du circuit photonique (1), la puce de test (20) comprenant un premier port de sortie (207, 207-VGC) destiné à être optiquement couplé au deuxième port d'entrée et un premier port d'entrée (207-VGC) destiné à être couplé au deuxième port de sortie ;
b) mettre la première face (201) de la puce de test en vis-à-vis d'une face (13) du circuit photonique (1) du côté de laquelle sont disposés les deuxièmes ports ; et
c) maximiser une quantité de lumière transmise du premier port de sortie au premier port d'entrée par l'intermédiaire du deuxième port d'entrée, du guide d'onde et du deuxième port de sortie.

17. Procédé selon la revendication 16, comprenant en outre, entre les étapes b) et c), une étape consistant à rendre parallèle la première face de la puce et ladite face du circuit photonique.
